# EUROPEAN PATENT APPLICATION

(11) **EP 4 686 028 A2**
(43) Date of publication of application: **28.01.2026**
(21) Application number: 25180852.3
(22) Date of filing: 04.06.2025
(51) Int. Cl.: H02J 1/08, H01M 10/48, H01M 10/42, H02J 1/10, H02J 7/00, H02J 9/06

(54) **REDUNDANT POWER DEVICE**

(30) Priority: 25.07.2024 KR 20240098352
(71) Applicant: SAMSUNG SDI CO., LTD., Yongin-si, Gyeonggi-do 17084 (KR)
(72) Inventor: KIM, Tae Jin, 16678 Suwon-si (KR); YANG, Jong Woon, 16678 Suwon-si (KR)
(74) Representative: Marks & Clerk LLP

(57) **Abstract**

The present disclosure relates to a redundant power device, and an object of the present disclosure is to provide a redundant power topology that can ensure normal operation of a battery management system (BMS) by securing normal operating power of the BMS even when a disconnection occurs in a cable connecting a battery cell and the BMS or an abnormality or failure occurs in an uppermost battery cell. The present disclosure provides a configuration of switching a power supply cable to a processor so that power is supplied to the processor through a sub-cable when an abnormality occurs in a main cable.

## Description

### FIELD

The present disclosure relates to a battery management system (BMS) with a redundant power structure.

### BACKGROUND

A battery management system (BMS) monitors states of battery cells, battery modules, and battery packs and operates to perform a function of controlling or protecting a battery based on the monitoring result. For example, the BMS monitors a voltage, a current, a temperature, and a state of charge (SOC) of a battery cell and performs control operations such as balancing control, temperature control, and charging/discharging control of the battery cell based on the monitoring results or performs a protection operation such as switch control of preventing over-discharging or over-charging.

The above information disclosed in this Background section is for enhancement of understanding of the background of the present disclosure, and therefore, it may contain information that does not constitute related (or prior) art.

### SUMMARY

An object of the present technology is to provide a redundant power device that can ensure normal operation of a battery management system (BMS) by securing normal operating power of the BMS even when a disconnection occurs in a cable connecting an uppermost battery cell and the BMS or an abnormality or failure occurs in the uppermost battery cell.

However, objects that the present technology intends to achieve are not limited to the above-described objects and other objects that are not described may be clearly understood by those skilled in the art from the following description.

According to an aspect of the present technology, there is provided a redundant power device including a main cable configured to supply power from an uppermost node of a plurality of battery cells mutually connected in series to a processor applied to a battery management system (BMS); a sub-cable configured to supply power from a target node, among a plurality of serial connection nodes between the plurality of battery cells, to the processor; and a power switching element configured to switch a power supply cable to the processor such that the power is supplied to the processor through the main cable in a normal state and, when an abnormality occurs in the main cable, the power is supplied to the processor through the sub-cable.

In some embodiments, the power switching element is connected to the sub-cable, and whether the sub-cable is activated is determined according to whether the power switching element is turned on.

**In** some embodiments, the power switching element is turned off in the normal state such that the sub-cable is in a deactivated state, and when the abnormality occurs in the main cable, the power switching element is switched to be turned on such that the sub-cable is switched to an activated state.

**In** some embodiments, the power switching element is switched to be turned on in response to a voltage change at a power input of the processor, and wherein when the abnormality occurs in the main cable, since the power switching element is switched to be turned on in response to the voltage change at the power input node of the processor, the power supply cable to the processor is switched from the main cable to the sub-cable.

**In** some embodiments, the power switching element includes a first diode provided on the sub-cable such that a forward direction of the first diode is a direction from the target node to the processor.

**In** some embodiments, the redundant power device further comprises a second diode provided on the main cable such that a forward direction of the second diode is a direction from the uppermost node to the processor. It should be noted that in the present application use of ordinal numbers for elements, such as in the term "second diode", does not necessarily require the presence of another such element, in this case a first diode.

**In** some embodiments, a cathode of the second diode and a cathode of the first diode are commonly connected to a power input node of the processor.

**In** some embodiments, the second diode is turned on in the normal state, and the power is supplied to the processor through the main cable; since a voltage of the power input node of the processor drops when the abnormality occurs in the main cable, the first diode is switched to be turned on when the abnormality occurs; and when the first diode is switched to be turned on, the sub-cable is switched to an activated state, and the power supply cable to the processor is switched from the main cable to the sub-cable.

**In** some embodiments, a voltage of the target node is higher than or equal to a predefined minimum operating voltage for the processor.

According to some aspects, there is provided a redundant power device comprising a main cable unit which includes: a first main cable configured to supply power from an uppermost node of a first battery module including a plurality of battery cells mutually connected in series to a first monitoring processor for monitoring a state of each battery cell of the first battery module, and a second main cable configured to supply power from an uppermost node of a second battery module including a plurality of battery cells mutually connected in series to a second monitoring processor for monitoring a state of each battery cell of the second battery module; a sub-cable unit which includes: a first sub-cable configured to supply power from a first target node, among a plurality of serial connection nodes between the plurality of battery cells of the first battery module, to the second monitoring processor, and a second sub-cable configured to supply power from a second target node, among a plurality of serial connection nodes between the plurality of battery cells of the second battery module, to the first monitoring processor; and a power switching element unit configured to switch a power supply cable to the first and second monitoring processors such that power is supplied to the first and second monitoring processors through the main cable unit in a normal state and, when an abnormality occurs in the main cable unit, the power is supplied to the first and second monitoring processors through the sub-cable unit.

**In** some embodiments, the power switching element unit includes a first power switching element and a second power switching element; the first power switching element is connected to the first sub-cable, and whether the first sub-cable is activated is determined according to whether the first power switching element is turned on; and the second power switching element is connected to the second sub-cable, and whether the second sub-cable is activated is determined according to whether the second power switching element is turned on.

In some embodiments, in the normal state: the first power switching element is turned off such that the first sub-cable is in a first deactivated state, and when an abnormality occurs in the second main cable, the first power switching element is switched to be turned on such that the first sub-cable is switched to a first activated state; and the second power switching element is turned off such that the second sub-cable is in a second deactivated state, and when an abnormality occurs in the first main cable, the second power switching element is switched to be turned on such that the second sub-cable is switched to a second activated state.

In some embodiments, the second power switching element is switched to be turned on in response to a voltage change at a power input node of the first monitoring processor, and wherein when the abnormality occurs in the first main cable, since the second power switching element is switched to be turned on in response to the voltage change at the power input node of the first monitoring processor, the power supply cable to the first monitoring processor is switched from the first main cable to the second sub-cable; and wherein the first power switching element is switched to be turned on in response to a voltage change at a power input node of the second monitoring processor, and wherein when an abnormality occurs in the second main cable, since the first power switching element is switched to be turned on in response to the voltage change at the power input node of the second monitoring processor, the power supply cable to the second monitoring processor is switched from the second main cable to the first sub-cable.

In some embodiments, the first power switching element includes a third diode provided on the first sub-cable such that a forward direction of the third diode is a direction from the first target node to the second monitoring processor; and the second power switching element includes a fourth diode provided on the second sub-cable such that a forward direction of the fourth diode is a direction from the second target node to the first monitoring processor.

In some embodiments, the redundant power device further comprises a second diode provided on the first main cable such that a forward direction of the second diode is a direction from an uppermost node of the first battery module to the first monitoring processor; and a first diode provided on the second main cable such that a forward direction of the first diode is a direction from an uppermost node of the second battery module to the second monitoring processor.

In some embodiments, a cathode of the second diode and a cathode of the fourth diode are commonly connected to a power input node of the first monitoring processor; and a cathode of the first diode and a cathode of the third diode are commonly connected to a power input node of the second monitoring processor.

In some embodiments, the second diode is turned on in the normal state, and the power is supplied to the first monitoring processor through the first main cable; since a voltage of the power input node of the first monitoring processor drops when the abnormality occurs in the first main cable, the fourth diode is switched to be turned on; and when the fourth diode is switched to be turned on, the second sub-cable is switched to a fourth activated state, and thus the power supply cable to the first monitoring processor is switched from the first main cable to the second sub-cable.

In some embodiments, the first diode is turned on in the normal state, and the power is supplied to the second monitoring processor through the second main cable; since a voltage of the power input node of the second monitoring processor drops when the abnormality occurs in the second main cable, the third diode is switched to be turned on; and as the third diode is switched to be turned on, the first sub-cable is switched to a third activated state, and the power supply cable to the second monitoring processor is switched from the second main cable to the first sub-cable.

In some embodiments, a voltage of the first target node is higher than or equal to a predefined minimum operating voltage for the second monitoring processor; and a voltage of the second target node is higher than or equal to a predefined minimum operating voltage for the first monitoring processor.

In some embodiments, the first sub-cable and the second sub-cable are mutually insulated.

At least some of the above and other features of the invention are set out in the claims.

### BRIEF DESCRIPTION OF THE DRAWINGS

The following drawings accompanying this specification illustrate embodiments of the present disclosure, and further describe aspects and features of the present disclosure together with the detailed description of the present disclosure. Thus, the present disclosure should not be construed as being limited to the drawings:
FIG. 1 is a diagram illustrating an example of a battery management system (BMS) circuit structure to which a redundant power device is applied according to some embodiments described herein;
FIGS. 2 and 3 are diagrams illustrating a circuit structure of a redundant power device according to some embodiments described herein; and
FIG. 4 is a diagram illustrating a circuit structure of a redundant power device according to other embodiments described herein.

### DETAILED DESCRIPTION

Hereinafter, embodiments of the present disclosure will be described, in detail, with reference to the accompanying drawings. The terms or words used in this specification and claims should not be construed as being limited to the usual or dictionary meaning and should be interpreted as meaning and concept consistent with the technical idea of the present disclosure based on the principle that the inventor can be his/her own lexicographer to appropriately define the concept of the term to explain his/her invention in the best way.

The embodiments described in this specification and the configurations shown in the drawings are only some of the embodiments of the present disclosure and do not represent all of the technical ideas, aspects, and features of the present disclosure. Accordingly, it should be understood that there may be various equivalents and modifications that can replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C," "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

References to two compared elements, features, etc. as being "the same" may mean that they are "substantially the same." Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

When an arbitrary element is referred to as being disposed (or located or positioned) on or "above (or below)" or "on (or under)" a component, it may mean that the arbitrary element is placed in contact with the upper (or lower) surface of the component and may also mean that another component may be interposed between the component and any arbitrary element disposed (or located or positioned) on (or under) the component.

In addition, it will be understood that when an element is referred to as being "coupled," "linked" or "connected" to another element, the elements may be directly "coupled," "linked" or "connected" to each other, or an intervening element may be present therebetween, through which the element may be "coupled," "linked" or "connected" to another element. In addition, when a part is referred to as being "electrically coupled" to another part, the part can be directly connected to another part or an intervening part may be present therebetween such that the part and another part are indirectly connected to each other.

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

As discussed herein, a battery management system (BMS) may monitor states of battery cells, battery modules, and battery packs and may operate to perform a function of controlling or protecting a battery based on the monitoring result. For example, the BMS monitors a voltage, a current, a temperature, and a state of charge (SOC) of a battery cell and performs control operations such as balancing control, temperature control, and charging/discharging control of the battery cell based on the monitoring results or performs a protection operation such as switch control of preventing over-discharging or over-charging.

In a battery structure in which a plurality of battery cells are connected in series, the BMS may receive operating power from a cable connected to an uppermost battery cell and may perform the monitoring operation, the control operation, and the protection operation described above. In this single line power structure, when a disconnection occurs in a cable connecting the uppermost battery cell and the BMS, the BMS loses a route through which operating power is input and thus there is a problem in that the BMS cannot perform the monitoring operation, the control operation, and the protection operation that are essentially required for battery management. In addition, when an abnormality or failure occurs in the uppermost battery cell, the operating power cannot be supplied to the BMS and therefore normal operation of the BMS cannot be secured.

### 1. Battery management system (BMS) circuit structure

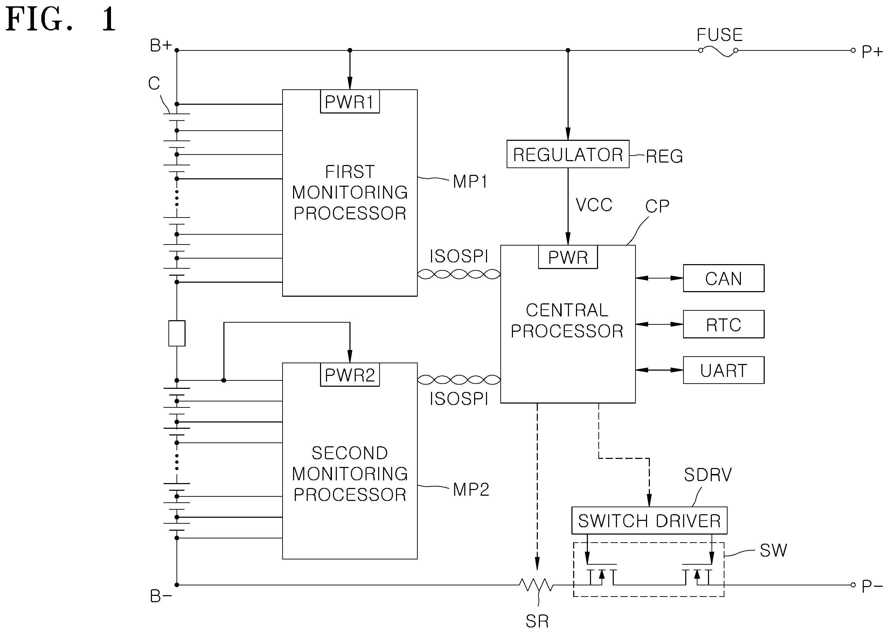

FIG. 1 shows an example of a BMS circuit structure to which a redundant power device is applied according to some embodiments described herein. In order to help understanding of the depicted embodiment, the BMS circuit structure to which the present embodiments are applied will be described with reference to FIG. 1.

Referring to FIG. 1, a BMS of the present embodiment may include first and second monitoring processors MP1 and MP2, a central processor CP, a shunt resistor SR, a charging/discharging switch SW, a switch driver SDRV, and a regulator REG and may be electrically connected to a plurality of battery cells C that are mutually connected in series.

The first and second monitoring processors MP1 and MP2 may correspond to analog front-ends (AFEs) that monitor a state of each battery cell C and perform a battery cell control operation based on the monitoring result. For example, each of the monitoring processors MP1 and MP2 may monitor a voltage, a current, a temperature, and a state of charge (SOC) of a battery cell C and perform control operations such as balancing control, temperature control, and charging/discharging control of the battery cell C based on the monitoring results or perform a protection operation such as control of the charging/discharging switch SW to prevent over-discharging or over-charging. The state data of the battery cell C (e.g., the voltage, the current, the temperature, and/or the SOC of the battery cell C) acquired by each of the monitoring processors MP1 and MP2 may be transmitted to the central processor CP, which will be described below, through isolated serial peripheral interface (isoSPI) communication. Meanwhile, in an example in which a battery cell C of a 32S(i.e. 32 battery cells) structure is provided, the first monitoring processor MP1 may correspond to an upper AFE monitoring states of 16 battery cells C at an upper end and performing balancing according to the monitored states, and the second monitoring processor MP2 may correspond to a lower AFE monitoring states of the 16 battery cells C at a lower end and performing balancing according to the monitored states.

The central processor CP may generate a control operation command or a protection operation command based on the state data of the battery cells C transmitted from the first and second monitoring processors MP1 and MP2 and feed the control operation command or the protection operation command back to the first and second monitoring processors MP1 and MP2, thereby allowing the first and second monitoring processors MP1 and MP2 to perform the above-described control operation or protection operation. The central processor CP performing such functions may correspond to a micro controller unit (MCU) of the BMS. The central processor CP may communicate with a higher-level controller (e.g., a vehicle electronic control unit (ECU)) through a communication protocol such as a controller area network (CAN), real time communication (RTC), or a universal asynchronous receiver-transmitter (UART).

The shunt resistor SR is connected to a path (corresponding to a charging/discharging path) from a positive terminal of a battery pack to a negative terminal thereof through the battery cell C and may serve as a resistance element for detecting an excessive current flowing in the battery cell C.

The charging/discharging switch SW may correspond to a metal oxide semiconductor field effect transistor (MOSFET) that controls a current flow on the above-described charging/discharging path, and the switch driver SDRV may correspond to a gate driver that controls an on/off operation of the charging/discharging switch SW under the control of the central processor CP.

A main device for performing an operation of detecting an overcurrent through the shunt resistor SR and an operation of controlling the on/off operation of the charging/discharging switch SW by controlling the switch driver SDRV when an overcurrent is detected may correspond to the first and second monitoring processors MP1 and MP2 or correspond to the central processor CP. FIG. 1 shows an example in which the main device for performing the above operations corresponds to the central processor CP. In this case, the central processor CP may operate to detect a state in which an overcurrent is flowing to the battery cell C through the shunt resistor SR and to control the switch driver SDRV to turn the charging/discharging switch SW off, thereby preventing the battery cell C from burning due to the overcurrent.

The regulator REG may regulate a voltage level at an uppermost node B+ of the plurality of battery cells C to a level corresponding to an operating voltage of the central processor CP, and an operating voltage VCC of the central processor CP may be generated by the regulator REG. The regulator REG may be implemented as a direct current (DC)/DC converter which converts a voltage at the uppermost node B+ of the plurality of battery cells C into the operating voltage of the central processor CP.

In the above-described BMS circuit structure, it can be confirmed that operating power of the first and second monitoring processors MP1 and MP2 and the central processor CP is supplied from the uppermost node B+ of the plurality of battery cells C. This means that when a disconnection occurs in the cable connecting the uppermost battery cell C and the BMS, or when an abnormality or failure occurs in the uppermost battery cell C, power cannot be supplied to the monitoring processors MP1 and MP2 and the central processor CP, and thus normal operation cannot be secured. Hereinafter, the redundant power structure employed in the present embodiments for supplying operating power to each of the monitoring processors MP1 and MP2 and the central processor CP when a disconnection occurs in the cable connecting the uppermost battery cell C and the BMS or when an abnormality or failure occurs in the uppermost battery cell C will be described in detail.

### 2. First embodiments of redundant power structure

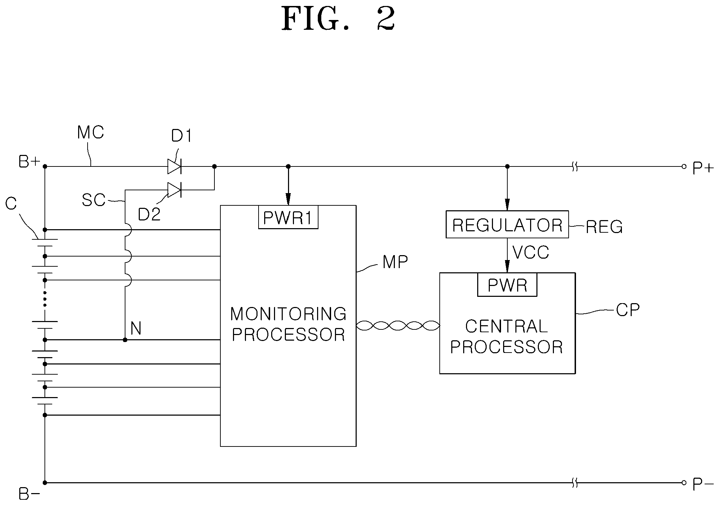

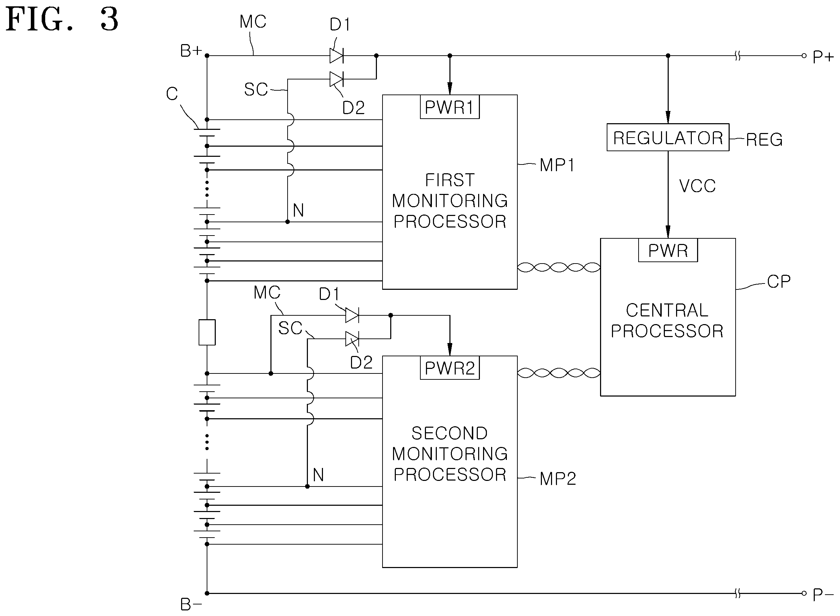

FIG. 2 shows a circuit structure of a redundant power device according to some embodiments described herein. FIG. 3 shows another circuit structure of a redundant power device according to some embodiments described herein. Referring to FIG. 2 first, the redundant power device of the first embodiments described herein may include a main cable MC, a sub-cable SC, and a power switching element (diode) D2.

The main cable MC may supply power from an uppermost node (hereinafter referred to as an uppermost node B+) of a plurality of battery cells C mutually connected in series to a processor applied to the BMS. The above-described processor applied to the BMS may be defined as a monitoring processor MP, a central processor CP, or both the monitoring processor MP and the central processor CP. Thus, the main cable MC may connect the uppermost node B+ of the plurality of battery cells C, a power input terminal of the monitoring processor MP, and a power input terminal of the central processor CP.

A diode D1 may be provided on the main cable MC. The diode D1 may be provided on the main cable MC such that a forward direction of the diode is a direction from the uppermost node B+ to the processor, that is, an anode of the diode D1 may be connected to the uppermost node B+ and a cathode thereof may be connected to the power input node of the processor (the monitoring processor MP). The diode D1 may serve as a reverse current prevention element preventing a reverse current to the uppermost node B+ in a normal state when no abnormality occurs in the main cable MC.

The sub-cable SC may supply power to a processor from a target node N among a plurality of serial connection nodes between the plurality of battery cells C. When an abnormality (defined as including a disconnection in the main cable MC or a failure in the uppermost battery cell C) occurs in the main cable MC, the sub-cable SC may serve as a redundancy cable for supplying power to the processor in place of the main cable MC, and thus the main cable MC and the sub-cable SC may form a redundant cable for power input to the processor.

The above-described target node N may be predetermined as a node with a voltage that is greater than or equal to a predefined minimum operating voltage for the processor, among the plurality of serial connection nodes between the battery cells C. For example, when the processor corresponds to the monitoring processor MP and the minimum operating voltage of the monitoring processor MP is 11 V, the target node N may be predetermined as a node with a voltage of 11 V or higher among the plurality of serial connection nodes. When the processor includes both the monitoring processor MP and the central processor CP, and when the minimum operating voltages of the monitoring processor MP and the central processor CP are 11 V and 12 V, respectively, the target node N may be predetermined as a node with a voltage of 12 V or higher, which is the higher voltage between 11 V and 12 V, among the plurality of serial connection nodes. That is, by employing a structure supplying redundant power from the target node N with a voltage that is greater than or equal to the minimum operating voltage required for normal operation of the monitoring processor MP or the central processor CP, a redundant power structure with no failure (as described herein) can be provided.

The power switching element (diode) D2 may switch a power supply cable to the processor so that power is supplied to the processor through the main cable MC in a normal state (e.g., a state in which no abnormality occurs in the main cable MC) and, when an abnormality occurs in the main cable MC, the power is supplied to the processor through the sub-cable SC (it is noted that, in the present specification, "switching" is used in a functional sense of changing the power supply cable from the main cable MC to the sub-cable SC and is not related to a physical switching element such as an FET or a relay, in some instances; and, in other instances, "switch" may be used to refer to a physical switching element such as in relation to the charging/discharging switch SW shown in FIG. 1).

As shown in FIG. 2, the power switching element (diode) D2 may include a diode D2 provided on the sub-cable SC such that a forward direction of the diode is a direction from the target node N to the processor. An anode of the diode D2 may be connected to the uppermost node B+ and a cathode thereof may be connected to the power input node of the processor (the monitoring processor MP). Thus, the cathode of diode D1 and the cathode of the diode D2 may be commonly connected to the power input node of the processor.

As described above, the diode D2 may be connected to the sub-cable SC, and whether the sub-cable SC is activated is determined according to whether the diode D2 is turned on. Specifically, since the diode D2 is turned off in a normal state, the sub-cable SC may become deactivated, and since the diode D2 is switched to be turned on when an abnormality occurs in the main cable MC, the sub-cable SC may be switched to an activated state.

Based on the above-described structure, when an abnormality occurs in the main cable MC, since the diode D2 is switched to be turned on in response to a voltage change at the power input node of the processor, the power supply cable to the processor may be switched from the main cable MC to the sub-cable SC.

The process of switching the power supply cable from the main cable MC to the sub-cable SC will now be described in a time-series manner, as an example.

First, since a forward voltage is formed in the diode D1 in a normal state, the diode D1 is turned on, and thus power is supplied to the processor through the main cable MC.

When an abnormality occurs in the main cable MC in the normal state, since an electrical connection between the power input node of the processor and the uppermost node B+ is cut off, a voltage of the power input node of the processor drops. When the voltage of the power input node of the processor is lower than or equal to a voltage of the target node N, since a forward voltage is formed in the diode D2, the diode D2 is switched to be turned on.

The sub-cable SC is switched to an activated state when the diode D2 is switched to be turned on, and thus the power supply cable to the processor is switched from the main cable MC to the sub-cable SC.

The above configuration may be applied equally not only to a case in which a single monitoring processor MP is provided, but also to a case where the plurality of monitoring processors MP1 and MP2 are provided as shown in FIG. 3.

### 3. Second embodiments of redundant power structure

In the first embodiments of the present disclosure, the case in which the processor, which is a main device for receiving the power through the sub-cable SC, is the monitoring processor or the central processor has been described. The second embodiments focus on implementing a redundant power structure through a sub-cable cross structure between battery modules in a structure in which a plurality of battery modules are provided and a plurality of monitoring processors corresponding to the battery modules are provided.

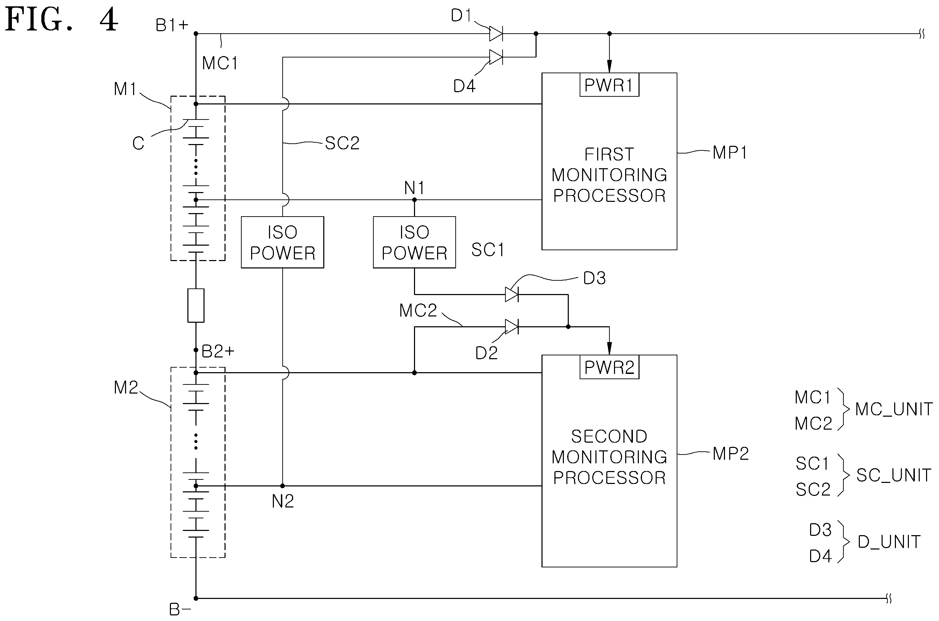

FIG. 4 shows a circuit structure of a redundant power device according to other embodiments described herein. Referring to FIG. 4, the redundant power device of the second embodiments may include a main cable unit MC_UNIT, a sub-cable unit SC_UNIT, and power switching element units D_UNIT (diodes) D3 and D4 (in order to help understand the depicted embodiment, a cable for monitoring a cell voltage of a battery cell C is not shown in FIG. 4).

The main cable unit MC_UNIT may include first and second main cables MC1 and MC2. The first main cable MC1 may supply power from an uppermost node B1+ of a first battery module M1, which includes a plurality of battery cells C mutually connected in series, to a first monitoring processor MP1 monitoring a state of each battery cell C of the first battery module M1. In addition, the second main cable MC2 may supply power from an uppermost node B2+ of a second battery module M2, which includes a plurality of battery cells C mutually connected in series, to a second monitoring processor MP2 monitoring a state of each battery cell C of the second battery module M2.

A diode D1 may be provided on the first main cable MC1. The diode D1 may be provided on the first main cable MC1 such that a forward direction of the diode is a direction from the uppermost node B1+ of the first battery module M1 to the first monitoring processor MP1, that is, an anode of the diode D1 may be connected to the uppermost node B1+ of the first battery module M1 and a cathode thereof may be connected to a power input node of the first monitoring processor MP1. The diode D1 may serve as a reverse current prevention device for preventing a reverse current to the uppermost node B1+ of the first battery module M1 in a normal state in which no abnormality occurs in the first main cable MC1.

A diode D2 may be provided on the second main cable MC2. The diode D2 may be provided on the second main cable MC2 such that a forward direction of the diode is a direction from the uppermost node B2+ of the second battery module M2 to the second monitoring processor MP2, that is, an anode of the diode D2 may be connected to the uppermost node B2+ of the second battery module M2 and a cathode thereof may be connected to a power input node of the second monitoring processor MP2. The diode D2 may serve as a reverse current prevention element for preventing a reverse current to the uppermost node B2+ of the second battery module M2 in a normal state in which no abnormality occurs in the second main cable MC2.

The sub-cable unit SC_UNIT may include first and second sub-cables SC1 and SC2. The first sub-cable SC1 may supply power from a first target node N1, among a plurality of serial connection nodes between the plurality of battery cells C of the first battery module M1, to the second monitoring processor MP2. In addition, the second sub-cable SC2 may supply power from a second target node N2, among a plurality of serial connection nodes between the plurality of battery cells C of the second battery module M2, to the first monitoring processor MP1. That is, the first sub-cable SC1 connects the first target node N1 of the first battery module M1 and the power input node of the second monitoring processor MP2, and the second sub-cable SC2 connects the second target node N2 of the second battery module M2 and the power input node of the first monitoring processor MP1. Thus, the first and second sub-cables SC1 and SC2 may connect the first and second monitoring processors MP1 and MP2 and the first and second battery modules M1 and M2 in a cross structure. In this case, the first sub-cable SC1 and the second sub-cable SC2 may be configured to be mutually insulated by an insulation structure ISO POWER as shown in FIG. 4, and an isolation capacitor connected between the first and second sub-cables SC1 and SC2 may be employed as an insulation structure.

Meanwhile, a voltage of the first target node N1 may be higher than or equal to a predefined minimum operating voltage for the second monitoring processor MP2, and a voltage of the second target node N2 may be higher than or equal to a predefined minimum operating voltage for the first monitoring processor MP1. Since this has been described in the first embodiments, a detailed description thereof will be omitted here, though such description applies to the second embodiments.

The power switching element units (diode D3 and diode D4) may switch the power supply cables to the first and second monitoring processors MP1 and MP2 such that power is supplied to the first and second monitoring processors MP1 and MP2 through the main cable unit MC_UNIT in a normal state and, when an abnormality occurs in the main cable unit MC_UNIT, the power is supplied to the first and second monitoring processors MP1 and MP2 through the sub-cable unit SC_UNIT.

As shown in FIG. 4, the power switching element units (diode D3 and diode D4) may include first and second power switching elements. The first power switching element may include the diode D3 provided on the first sub-cable SC1 such that a forward direction of the diode is a direction from the first target node N1 to the second monitoring processor MP2. Thus, a cathode of the diode D3 and a cathode of the diode D2 may be commonly connected to the power input node of the second monitoring processor MP2. In addition, the second power switching element may include the diode D4 provided on the second sub-cable SC2 such that a forward direction of the diode is a direction from the second target node N2 to the first monitoring processor MP1. Thus, the cathode of the diode D1 and a cathode of the diode D4 may be commonly connected to the power input node of the first monitoring processor MP1.

As described above, the diode D3 may be connected to the first sub-cable SC1, and whether the first sub-cable SC1 is activated is determined according to whether the diode D3 is turned on. Specifically, since the diode D3 is turned off in a normal state, the first sub-cable SC1 may become deactivated, and since the diode D3 is switched to be turned on when an abnormality occurs in the second main cable MC2, the first sub-cable SC1 may be switched to an activated state.

In addition, the diode D4 may be connected to the second sub-cable SC2, and whether the second sub-cable SC2 is activated is determined according to whether the diode D4 is turned on. Specifically, since the diode D4 is turned off in a normal state, the second sub-cable SC2 may become deactivated, and since the diode D4 is switched to be turned on when an abnormality occurs in the first main cable MC1, the second sub-cable SC2 may be switched to an activated state.

Based on the above-described structure, when an abnormality occurs in the first main cable MC1, since the diode D4 is switched to be turned on in response to a voltage change at the power input node of the first monitoring processor MP1, the power supply cable to the first monitoring processor MP1 may be switched from the first main cable MC1 to the second sub-cable SC2. In addition, when an abnormality occurs in the second main cable MC2, since the diode D3 is switched to be turned on in response to a voltage change at the power input node of the second monitoring processor MP2, the power supply cable to the second monitoring processor MP2 may be switched from the second main cable MC2 to the first sub-cable SC1.

The process of switching the power supply cable from the first main cable MC1 to the second sub-cable SC2 will now be described in a time-series manner, as an example.

First, since a forward voltage is formed in the diode D1 in a normal state, the diode D1 is turned on, and thus power is supplied to the first monitoring processor MP1 through the first main cable MC1.

When an abnormality occurs in the first main cable MC1 in the above normal state, an electrical connection between the power input node of the first monitoring processor MP1 and the uppermost node B1+ of the first battery module M1 is cut off so that a voltage of the power input node of the first monitoring processor MP1 drops. When the voltage of the power input node of the first monitoring processor MP1 is lower than or equal to a voltage of the second target node N2, since a forward voltage is formed in the diode D4, the diode D4 is switched to be turned on.

The second sub-cable SC2 is switched to an activated state as the diode D4 is switched to be turned on, and thus the power supply cable to the first monitoring processor MP1 is switched from the first main cable MC1 to the second sub-cable SC2.

Through the above process, when an abnormality occurs in the first main cable MC1, the first monitoring processor MP1 receives operating power from the second target node N2 of the second battery module M2 rather than the first battery module M1 through the second sub-cable SC2. Considering that the abnormality of the first main cable MC1 may be caused by an abnormality of the first battery module M1, a more robust redundant power structure can be provided in some embodiments by securing the operating power of the first monitoring processor MP1 from the second battery module M2 rather than the first battery module M1.

Next, the process of switching the power supply cable from the second main cable MC2 to the first sub-cable SC1 will be described in a time-series manner.

First, since a forward voltage is formed in the diode D2 in a normal state, the diode D2 is turned on, and thus power is supplied to the second monitoring processor MP2 through the second main cable MC2.

When an abnormality occurs in the second main cable MC2 in the above normal state, an electrical connection between the power input node of the second monitoring processor MP2 and the uppermost node B2+ of the second battery module M2 is cut off so that a voltage of the power input node of the second monitoring processor MP2 drops. When the voltage of the power input node of the second monitoring processor MP2 is lower than or equal to a voltage of the first target node N1, since a forward voltage is formed in the diode D3, the diode D3 is switched to be turned on.

The first sub-cable SC1 is switched to an activated state as the diode D3 is switched to be turned on, and thus the power supply cable to the second monitoring processor MP2 is switched from the second main cable MC2 to the first sub-cable SC1.

Through the above process, when an abnormality occurs in the second main cable MC2, the second monitoring processor MP2 receives operating power from the first target node N1 of the first battery module M1 rather than the second battery module M2 through the first sub-cable SC1. Considering that the abnormality of the second main cable MC2 may be caused by an abnormality of the second battery module M2, a more robust redundant power structure can be provided in some embodiments by securing the operating power of the second monitoring processor MP2 from the first battery module M1 rather than the second battery module M2.

As described above, according to the present technology, by employing the circuit structure in which, together with the main cable for supplying the power from the uppermost battery cell to the BMS, the sub-cable for supplying the power from the target node, among the plurality of serial connection nodes between the plurality of battery cells, to the BMS is provided, and the power supply cable can be switched such that the power is supplied to the BMS through the sub-cable when an abnormality occurs in the main cable, even when a disconnection occurs in the cable connecting the uppermost battery cell and the BMS, or even when an abnormality or failure occurs in the uppermost battery cell, normal operation of the BMS can be ensured by securing the normal operating power of the BMS.

The embodiments described herein may be implemented, for example, as a method or process, a device, a software program, a data stream, or a signal. Although discussed in the context of a single type of implementation (for example, discussed only as a device), features discussed herein may also be implemented in other forms (for example, a method or a program). The device may be implemented by suitable hardware, software, firmware, and the like. The method may be implemented on a device, such as a processor that generally refers to a processing device including a computer, a microprocessor, an integrated circuit, a programmable logic device, etc. The processor includes a communication device such as a computer, a cell phone, a personal digital assistant (PDA), and other devices that facilitate communication of information between the device and end-users.

According to the present technology, by employing a circuit structure in which, together with the main cable for supplying the power from the uppermost battery cell to the BMS, the sub-cable for supplying the power from the target node, among the plurality of serial connection nodes between the plurality of battery cells, to the BMS is provided, and the power supply cable is switched such that the power is supplied to the BMS through the sub-cable when an abnormality occurs in the main cable, even when a disconnection occurs in the cable connecting the uppermost battery cell and the BMS, or even when an abnormality or failure occurs in the uppermost battery cell, normal operation of the BMS can be ensured by securing the normal operating power of the BMS.

Although the present disclosure has been described with reference to embodiments and drawings illustrating aspects thereof, the present disclosure is not limited thereto. Various modifications and variations can be made by a person skilled in the art to which the present disclosure belongs within the scope of the present disclosure and the claims and their equivalents, below.

Embodiments are set out in the following clauses:
1. A redundant power device comprising:
   a main cable configured to supply power from an uppermost node of a plurality of battery cells mutually connected in series to a processor applied to a battery management system (BMS);
   a sub-cable configured to supply power from a target node, among a plurality of serial connection nodes between the plurality of battery cells, to the processor; and
   a power switching element configured to switch a power supply cable to the processor such that the power is supplied to the processor through the main cable in a normal state and, when an abnormality occurs in the main cable, the power is supplied to the processor through the sub-cable.
2. The redundant power device of clause 1, wherein the power switching element is connected to the sub-cable, and whether the sub-cable is activated is determined according to whether the power switching element is turned on, and
   wherein the power switching element is turned off in the normal state such that the sub-cable is in a deactivated state, and when the abnormality occurs in the main cable, the power switching element is switched to be turned on such that the sub-cable is switched to an activated state.
3. The redundant power device of clause 2, wherein the power switching element is switched to be turned on in response to a voltage change at a power input of the processor, and wherein when the abnormality occurs in the main cable, since the power switching element is switched to be turned on in response to the voltage change at the power input node of the processor, the power supply cable to the processor is switched from the main cable to the sub-cable.
4. The redundant power device of clause 2 or 3, wherein the power switching element includes a first diode provided on the sub-cable such that a forward direction of the first diode is a direction from the target node to the processor.
5. The redundant power device of clause 4, further comprising a second diode provided on the main cable such that a forward direction of the second diode is a direction from the uppermost node to the processor, and
   wherein a cathode of the second diode and a cathode of the first diode are commonly connected to a power input node of the processor.
6. The redundant power device of clause 5, wherein:
   the second diode is turned on in the normal state, and the power is supplied to the processor through the main cable;
   since a voltage of the power input node of the processor drops when the abnormality occurs in the main cable, the first diode is switched to be turned on when the abnormality occurs; and
   when the first diode is switched to be turned on, the sub-cable is switched to an activated state, and the power supply cable to the processor is switched from the main cable to the sub-cable.
7. A redundant power device comprising:
   a main cable unit which includes:
   a first main cable configured to supply power from an uppermost node of a first battery module including a plurality of battery cells mutually connected in series to a first monitoring processor for monitoring a state of each battery cell of the first battery module, and
   a second main cable configured to supply power from an uppermost node of a second battery module including a plurality of battery cells mutually connected in series to a second monitoring processor for monitoring a state of each battery cell of the second battery module;
   a sub-cable unit which includes:
      a first sub-cable configured to supply power from a first target node, among a plurality of serial connection nodes between the plurality of battery cells of the first battery module, to the second monitoring processor, and
      a second sub-cable configured to supply power from a second target node, among a plurality of serial connection nodes between the plurality of battery cells of the second battery module, to the first monitoring processor; and
      a power switching element unit configured to switch a power supply cable to the first and second monitoring processors such that power is supplied to the first and second monitoring processors through the main cable unit in a normal state and, when an abnormality occurs in the main cable unit, the power is supplied to the first and second monitoring processors through the sub-cable unit.
8. The redundant power device of clause 7, wherein:
   the power switching element unit includes a first power switching element and a second power switching element;
   the first power switching element is connected to the first sub-cable, and whether the first sub-cable is activated is determined according to whether the first power switching element is turned on; and
   the second power switching element is connected to the second sub-cable, and whether the second sub-cable is activated is determined according to whether the second power switching element is turned on.
9. The redundant power device of clause 8, wherein, in the normal state:
   the first power switching element is turned off such that the first sub-cable is in a first deactivated state, and when an abnormality occurs in the second main cable, the first power switching element is switched to be turned on such that the first sub-cable is switched to a first activated state; and
   the second power switching element is turned off such that the second sub-cable is in a second deactivated state, and when an abnormality occurs in the first main cable, the second power switching element is switched to be turned on such that the second sub-cable is switched to a second activated state.
10. The redundant power device of clause 9, wherein the second power switching element is switched to be turned on in response to a voltage change at a power input node of the first monitoring processor, and wherein when the abnormality occurs in the first main cable, since the second power switching element is switched to be turned on in response to the voltage change at the power input node of the first monitoring processor, the power supply cable to the first monitoring processor is switched from the first main cable to the second sub-cable; and
   wherein the first power switching element is switched to be turned on in response to a voltage change at a power input node of the second monitoring processor, and wherein when an abnormality occurs in the second main cable, since the first power switching element is switched to be turned on in response to the voltage change at the power input node of the second monitoring processor, the power supply cable to the second monitoring processor is switched from the second main cable to the first sub-cable.
11. The redundant power device of clause 8, 9 or 10, wherein:
   the first power switching element includes a third diode provided on the first sub-cable such that a forward direction of the third diode is a direction from the first target node to the second monitoring processor; and
   the second power switching element includes a fourth diode provided on the second sub-cable such that a forward direction of the fourth diode is a direction from the second target node to the first monitoring processor.
12. The redundant power device of clause 11, further comprising:
   a second diode provided on the first main cable such that a forward direction of the second diode is a direction from an uppermost node of the first battery module to the first monitoring processor; and
   a first diode provided on the second main cable such that a forward direction of the first diode is a direction from an uppermost node of the second battery module to the second monitoring processor,
   wherein:
      a cathode of the second diode and a cathode of the fourth diode are commonly connected to a power input node of the first monitoring processor; and
      a cathode of the first diode and a cathode of the third diode are commonly connected to a power input node of the second monitoring processor.
13. The redundant power device of clause 12, wherein:
   the second diode is turned on in the normal state, and the power is supplied to the first monitoring processor through the first main cable;
   since a voltage of the power input node of the first monitoring processor drops when the abnormality occurs in the first main cable, the fourth diode is switched to be turned on; and
   when the fourth diode is switched to be turned on, the second sub-cable is switched to a fourth activated state, and thus the power supply cable to the first monitoring processor is switched from the first main cable to the second sub-cable.
14. The redundant power device of clause 12 or 13, wherein:
   the first diode is turned on in the normal state, and the power is supplied to the second monitoring processor through the second main cable;
   since a voltage of the power input node of the second monitoring processor drops when the abnormality occurs in the second main cable, the third diode is switched to be turned on; and
   as the third diode is switched to be turned on, the first sub-cable is switched to a third activated state, and the power supply cable to the second monitoring processor is switched from the second main cable to the first sub-cable.
15. The redundant power device of any one of clauses 7 to 14, wherein:
   a voltage of the first target node is higher than or equal to a predefined minimum operating voltage for the second monitoring processor; and
   a voltage of the second target node is higher than or equal to a predefined minimum operating voltage for the first monitoring processor.

## Claims

1. A redundant power device comprising:
a main cable configured to supply power from an uppermost node of a plurality of battery cells mutually connected in series to a processor applied to a battery management system (BMS);
a sub-cable configured to supply power from a target node, among a plurality of serial connection nodes between the plurality of battery cells, to the processor; and
a power switching element configured to switch a power supply cable to the processor such that the power is supplied to the processor through the main cable in a normal state and, when an abnormality occurs in the main cable, the power is supplied to the processor through the sub-cable.

2. The redundant power device of claim 1, wherein the power switching element is connected to the sub-cable, and whether the sub-cable is activated is determined according to whether the power switching element is turned on, and
wherein the power switching element is turned off in the normal state such that the sub-cable is in a deactivated state, and when the abnormality occurs in the main cable, the power switching element is switched to be turned on such that the sub-cable is switched to an activated state.

3. The redundant power device of claim 2, wherein the power switching element is switched to be turned on in response to a voltage change at a power input of the processor, and wherein when the abnormality occurs in the main cable, since the power switching element is switched to be turned on in response to the voltage change at the power input node of the processor, the power supply cable to the processor is switched from the main cable to the sub-cable.

4. The redundant power device of claim 2 or 3, wherein the power switching element includes a second diode provided on the sub-cable such that a forward direction of the second diode is a direction from the target node to the processor.

5. The redundant power device of claim 4, further comprising a first diode provided on the main cable such that a forward direction of the first diode is a direction from the uppermost node to the processor, and
wherein a cathode of the first diode and a cathode of the second diode are commonly connected to a power input node of the processor.

6. The redundant power device of claim 5, wherein:
the first diode is turned on in the normal state, and the power is supplied to the processor through the main cable;
since a voltage of the power input node of the processor drops when the abnormality occurs in the main cable, the second diode is switched to be turned on when the abnormality occurs; and
when the second diode is switched to be turned on, the sub-cable is switched to an activated state, and the power supply cable to the processor is switched from the main cable to the sub-cable.

7. A redundant power device comprising:
a main cable unit which includes:
a first main cable configured to supply power from an uppermost node of a first battery module including a plurality of battery cells mutually connected in series to a first monitoring processor for monitoring a state of each battery cell of the first battery module, and
a second main cable configured to supply power from an uppermost node of a second battery module including a plurality of battery cells mutually connected in series to a second monitoring processor for monitoring a state of each battery cell of the second battery module;
a sub-cable unit which includes:
a first sub-cable configured to supply power from a first target node, among a plurality of serial connection nodes between the plurality of battery cells of the first battery module, to the second monitoring processor, and
a second sub-cable configured to supply power from a second target node, among a plurality of serial connection nodes between the plurality of battery cells of the second battery module, to the first monitoring processor; and
a power switching element unit configured to switch a power supply cable to the first and second monitoring processors such that power is supplied to the first and second monitoring processors through the main cable unit in a normal state and, when an abnormality occurs in the main cable unit, the power is supplied to the first and second monitoring processors through the sub-cable unit.

8. The redundant power device of claim 7, wherein:
the power switching element unit includes a first power switching element and a second power switching element;
the first power switching element is connected to the first sub-cable, and whether the first sub-cable is activated is determined according to whether the first power switching element is turned on; and
the second power switching element is connected to the second sub-cable, and whether the second sub-cable is activated is determined according to whether the second power switching element is turned on.

9. The redundant power device of claim 8, wherein, in the normal state:
the first power switching element is turned off such that the first sub-cable is in a first deactivated state, and when an abnormality occurs in the second main cable, the first power switching element is switched to be turned on such that the first sub-cable is switched to a first activated state; and
the second power switching element is turned off such that the second sub-cable is in a second deactivated state, and when an abnormality occurs in the first main cable, the second power switching element is switched to be turned on such that the second sub-cable is switched to a second activated state.

10. The redundant power device of claim 9, wherein the second power switching element is switched to be turned on in response to a voltage change at a power input node of the first monitoring processor, and wherein when the abnormality occurs in the first main cable, since the second power switching element is switched to be turned on in response to the voltage change at the power input node of the first monitoring processor, the power supply cable to the first monitoring processor is switched from the first main cable to the second sub-cable; and
wherein the first power switching element is switched to be turned on in response to a voltage change at a power input node of the second monitoring processor, and wherein when an abnormality occurs in the second main cable, since the first power switching element is switched to be turned on in response to the voltage change at the power input node of the second monitoring processor, the power supply cable to the second monitoring processor is switched from the second main cable to the first sub-cable.

11. The redundant power device of claim 8, 9 or 10, wherein:
the first power switching element includes a third diode provided on the first sub-cable such that a forward direction of the third diode is a direction from the first target node to the second monitoring processor; and
the second power switching element includes a fourth diode provided on the second sub-cable such that a forward direction of the fourth diode is a direction from the second target node to the first monitoring processor.

12. The redundant power device of claim 11, further comprising:
a first diode provided on the first main cable such that a forward direction of the second diode is a direction from an uppermost node of the first battery module to the first monitoring processor; and
a second diode provided on the second main cable such that a forward direction of the first diode is a direction from an uppermost node of the second battery module to the second monitoring processor,
wherein:
a cathode of the first diode and a cathode of the fourth diode are commonly connected to a power input node of the first monitoring processor; and
a cathode of the second diode and a cathode of the third diode are commonly connected to a power input node of the second monitoring processor.

13. The redundant power device of claim 12, wherein:
the first diode is turned on in the normal state, and the power is supplied to the first monitoring processor through the first main cable;
since a voltage of the power input node of the first monitoring processor drops when the abnormality occurs in the first main cable, the fourth diode is switched to be turned on; and
when the fourth diode is switched to be turned on, the second sub-cable is switched to a fourth activated state, and the power supply cable to the first monitoring processor is switched from the first main cable to the second sub-cable.

14. The redundant power device of claim 12 or 13, wherein:
the second diode is turned on in the normal state, and the power is supplied to the second monitoring processor through the second main cable;
since a voltage of the power input node of the second monitoring processor drops when the abnormality occurs in the second main cable, the third diode is switched to be turned on; and
when the third diode is switched to be turned on, the first sub-cable is switched to a third activated state, and the power supply cable to the second monitoring processor is switched from the second main cable to the first sub-cable.

15. The redundant power device of any one of claims 7 to 14, wherein:
a voltage of the first target node is higher than or equal to a predefined minimum operating voltage for the second monitoring processor; and
a voltage of the second target node is higher than or equal to a predefined minimum operating voltage for the first monitoring processor.
